# EUROPEAN PATENT SPECIFICATION

(11) **EP 4 629 454 B1**
(45) Date of publication and mention of the grant of the patent: **07.10.2026**
(21) Application number: 24168736.7
(22) Date of filing: 05.04.2024
(51) Int. Cl.: H01S 5/042, H01S 5/065, H01S 5/062, H01S 5/32

(54) **A DEVICE AND A METHOD FOR MODULATION OF AN OPTICAL SIGNAL**
VORRICHTUNG UND VERFAHREN ZUR MODULATION EINES OPTISCHEN SIGNALS
DISPOSITIF ET PROCÉDÉ DE MODULATION D'UN SIGNAL OPTIQUE

(43) Date of publication of application: 08.10.2025
(73) Proprietor: Imec VZW, 3001 Leuven (BE); Katholieke Universiteit Leuven KU Leuven Research & Development, 3000 Leuven (BE)
(72) Inventor: GEHLHAAR, Robert, 3020 Herent (BE); ELKHOULY, Karim, 3000 Leuven (BE); CROES, Guillaume, 3570 Alken (BE); GENOE, Jan, 3272 Testelt (BE)
(74) Representative: AWA Sweden AB

(56) References cited:
- EP-A1- 3 664 233
- US-A1- 2004 105 476
- US-A1- 2020 142 181
- US-A1- 2023 023 686
- US-B1- 9 843 160
- US-B2- 7 013 072

## Description

### Technical field

The present description relates to modulation of an optical signal. In particular, the present description relates to a device and a method for modulation of an optical signal.

The project leading to this application has received funding from the European Research Council (ERC) under the European Union's Horizon 2020 research and innovation program (grant agreement No 835133).

### Background

There are many applications in which control of an optical signal is desired. For instance, in applications, an optical signal may be controlled for ensuring laser operation and/or for providing amplification of the optical signal. In addition, in applications, the optical signal may be controlled for providing beam steering and/or controlling direction, amplitude, phase and/or wavelength of the optical signal. The optical signal may be controlled by providing modulation of the optical signal.

Applications in which modulation of the optical signal may be used include wavelength tuning, phase shifting and beam steering of a laser signal, generation of a three-dimensional light field for forming holographic images, and an optical processing unit for performing operations on data, such as an optical central processing unit (CPU).

There is a need for providing accurate modulation of an optical signal in a simple manner. There is further a need for providing the accurate modulation in a compact device, such that the modulation of the optical signal may be provided in a photonic integrated circuit. EP 3 664 233 A1, US 2004/0105476 A1, US 9 843 160 B1, US 7 013 072 B2, US 2020/0142181 A1, US 2023/0023686 A1 disclose similar devices for modulation of an optical signal.

### Summary

An objective of the present description is to enable accurate modulation of an optical signal in a simple and compact manner.

These and other objectives are at least partly met by the invention as defined in the independent claims. Preferred embodiments are set out in the dependent claims.

According to a first aspect, there is provided a device for modulation of an optical signal, said device comprising: an active layer configured to provide electrically controlled gain of the optical signal; an electrode layer arranged to extend along the active layer, wherein the electrode layer comprises a plurality of separate electrodes associated with respective parts of the active layer, wherein each electrode of the plurality of electrodes have a size of a cross-section in the electrode layer smaller than a wavelength of the optical signal and neighboring electrodes are separated by a distance smaller than the wavelength of the optical signal; wherein an electrical signal to each of the plurality of separate electrodes is controllable for locally modulating an imaginary part of a refractive index of the active layer by locally controlling an electrical signal in the active layer.

The optical signal may be generated in the active layer. The electrode layer is further configured to locally control optical gain in the active layer. Thanks to the plurality of electrodes, the electrode layer is configured to provide local modulation over a lateral extension of the active layer. This implies that the plurality of electrodes may together provide an overall effect of the optical signal in the active layer so as to provide an accurate control of the optical signal.

The local modulation provided by the electrodes may be very small. Nevertheless, a large overall impact on the optical signal may be provided by using a combination of the local modulations provided by electrical signals to the plurality of electrodes.

The electrode layer provides an electro-optical effect by the electrical signal to the electrodes providing optical modulation. Further, the plurality of electrodes provides a spatial control of optical feedback in the active layer.

Thanks to dimensions of the electrodes being smaller than a wavelength of the optical signal, the electrode layer may provide accurately controlled modulation of the optical signal. In some embodiments, the electrode layer may form a metamaterial.

The electrical signal provided to the electrodes provides a local control of an electrical signal in the active layer. This control of the electrical signal in the active layer may in turn affect local modulation of the imaginary part of the refractive index of the active layer. The imaginary part of the refractive index may also be referred to as an optical extinction coefficient and is related to loss of the optical signal in the active layer. This implies that an optical gain of the active layer may be locally modulated.

The electrodes may be configured to mainly affect the imaginary part of the refractive index and not to affect a real part of the refractive index. This implies that the device may not affect resonance conditions which may be based on a variation of a real part of the refractive index of the active layer.

The modulation of the imaginary part of the refractive index of the active layer may be used for modulating amplitude, phase and/or wavelength of the optical signal. This may for instance be used for controlling beam steering (direction) of the optical signal, for controlling a three-dimensional light field output by the device (for controlling a holographic image), and/or for providing optical processing of data.

The active layer may comprise two opposite surfaces. The active layer may have a large extension in a direction along the surfaces. The active layer may further have a relatively small thickness between the surfaces, such that the extension of the surfaces is much larger than the thickness of the active layer.

The active layer may have a uniform thickness over the entire active layer. The active layer may further be planar. Thus, the active layer may be configured to extend in a plane. However, it should be realized that the active layer may not necessarily have a uniform thickness and/or be planar.

The optical signal may be configured to propagate in the active layer. This implies that the local modulations provided by the electrode signals to the electrodes may sequentially in time affect the optical signal as the optical signal propagates through the active layer.

However, the optical signal may alternatively be configured to be output as distributed beam or wavefront from a surface of the active layer. This implies that the local modulations provided by the electrode signals to the electrodes may affect spatially different parts of the optical signal for providing an overall control of the optical signal.

The electrode layer may comprise two opposite surfaces. The electrode layer may have a large extension in a direction along the surfaces. The electrode layer may further have a relatively small thickness between the surfaces, such that the extension of the surfaces is much larger than the thickness of the electrode layer.

The electrode layer may have a uniform thickness over the entire electrode layer. The electrode layer may further be planar. Thus, the electrode layer may be configured to extend in a plane. However, it should be realized that the electrode layer may not necessarily have a uniform thickness and/or be planar.

The electrode layer may be configured to extend along the active layer such that a surface of the electrode layer extend over an area corresponding to a surface of the active layer. The surface of the electrode layer may have a shape conforming to a shape of the active layer. For instance, the active layer and the electrode layer may both be planar and may be arranged to extend in parallel planes.

The plurality of electrodes may be distributed over the extension of the electrode layer. Thus, different electrodes may be arranged in different parts of the electrode layer and may be separated along the extension of the electrode layer. This further implies that each electrode may be associated with a different part of the active layer, wherein the different parts of the active layers are arranged at different locations along the extension of the active layer.

Each electrode may extend through the thickness of the electrode layer. This implies that the electrode may have a contact for receiving an electrical signal at a first surface of the electrode layer facing away from the active layer and may provide the electrical signal into the active layer at a second surface of the electrode layer facing the active layer. This facilitates providing the electrical signal to the electrodes without a circuitry or contacts for providing the electrical signal affecting the optical signal in the active layer.

However, it should be realized that the electrodes need not necessarily extend through the entire thickness of the electrode. For instance, electrodes may not be arranged at the surface of the electrode layer facing the active layer but may instead have an end within the electrode layer.

The size of a cross-section of an electrode may provide a characteristic dimension of the electrode. The electrode may have various cross-sectional shapes. For instance, the electrode may be circular or rectangular. Thus, the size of the cross-section of the electrode may for instance correspond to a diameter or a width of the cross-section.

Neighboring electrodes should be understood as electrodes being closest neighbors. Thus, the separation of neighboring electrodes corresponds to smallest distances between electrodes in the electrode layer.

It should be realized that the optical signal may comprise a range of wavelengths. The size of the electrodes and the distances between electrodes being smaller than the wavelength of the optical signal may thus imply that the size of the electrodes and the distances between electrodes being smaller than a smallest wavelength in the range of wavelengths of the optical signal.

The wavelength of the optical signal may correspond to a visible wavelength. However, it should be realized that the optical signal is not necessarily provided in the visible part of the electromagnetic spectrum. Rather, the optical signal may alternatively or additionally have a wavelength in the ultraviolet, near-infrared or infrared part of the electromagnetic spectrum.

It should be realized that each of the plurality of electrodes may be identical. Thus, all electrodes may have an identical size and shape. Further, the plurality of electrodes may be regularly arranged in the electrode layer, such as being arranged in a one-dimensional or two-dimensional array with equal distances between electrodes along rows and/or columns of the array. Regular arrangement of identical electrodes may provide a well-structured control of the gain of the optical signal.

However, it should be realized that the electrodes need not necessarily be identical and/or arranged regularly. This may facilitate providing different accuracy of control in different parts of the active layer. This may be useful if it is particularly important to provide accurate control in some parts of the active layer.

The electrical signals provided to the electrodes may be controlled for controlling the local modulation of the optical signal in the active layer. Each electrode may receive an individually controlled electrical signal. However, it should be realized that some electrodes may be connected to receive the same electrical signals.

The electrical signal to the electrodes may for instance be a voltage signal or a current signal. The electrical signal provided to the electrodes may locally control an electrical signal in the active layer. The electrical signal in the active layer may for instance be an electric field in the active layer or charge carriers injected into the active layer.

The electrodes may be formed by a conducting material, such as a metal. The electrodes may define a location at which the electrical signal in the electrode leaves into a different medium, such as a non-metallic medium. The device may comprise one or more further electrodes, which may be used for providing a potential difference between the electrodes of the electrode layer and the further electrodes for providing the electrical signal in the active layer. Alternatively, different electrodes in the electrode layer may receive different electrical signals, such as positive and negative signals, respectively, such that the electrical signal in the active layer may be defined by the different electrical signals provided to adjacent electrodes in the electrode layer.

The active layer and the electrode layer may be in contact with each other. However, according to an alternative, there may be one or more intermediate layers arranged between the active layer and the electrode layer.

According to an embodiment, each electrode is associated with an individual control circuitry for controlling the electrical signal provided to the electrode.

This implies that the electrical signal provided to each electrode may be individually controlled. This further implies that the local modulation of the optical signal in each part of the active layer may be individually controlled. This provides a very accurate control of the optical signal in the active layer.

The individual control circuitry may be connected to the electrode. The device may comprise a connection layer which is configured to extend along the electrode layer, wherein the electrode layer may be arranged between the connection layer and the active layer.

The individual control circuitries may be arranged in the connection layer. Alternatively, the connection layer may merely comprise connections, such as wires extending in the connection layer. This implies that the individual control circuitries need not be arranged in a stack with the electrode layer and the active layer. This may allow a larger footprint of the individual control circuitries to be used, wherein the individual control circuitries may be laterally displaced in relation to the active layer and the electrode layer.

According to an embodiment, the electrical signal to each of the plurality of separate electrodes is selectively turned on or off.

This is a simple manner of controlling the local modulation of the optical signal in the active layer. The electrical signal may thus for instance be controlled using a memory element with a single bit, which may be used for setting the electrical signal to a zero or one for turning on or off the electrical signal to the electrode.

However, it should be realized that the electrical signals to the electrodes may be controlled in different manners. For instance, the electrical signal may be controlled to assume one of a plurality of levels. This provides even more accurate control of the local modulation of the optical signal in the active layer. Multilevel control of the electrical signal may be provided by memory elements carrying more than one bit. As a further alternative, the electrical signal may be controlled in an analog manner. For instance, the electrical signal may be freely controlled within a range of values.

Local modulation of gain in the active layer may be proportional to the electrical signal provided to the electrode. Thus, by providing a free variation of the electrical signal provided to the electrode, free and proportional control of the local gain modulation in the active layer may be provided. This facilitates very accurate control of the modulation of the optical signal.

According to an embodiment, the electrode layer is formed by a metamaterial comprising an electrically conducting material and an electrically insulating material, wherein portions of the electrically conducting material form the plurality of separate electrodes.

Thus, the plurality of electrodes may be provided by electrically conducting material arranged in a metamaterial. The electrically conducting material of each electrode may be surrounded by insulating material, such that the insulating material provides a separation between separate electrodes.

According to an embodiment, the electrically conducting material and the insulating material have a same refractive index.

The electrically conducting material and the insulating material may have a same real part of the refractive index at least in a spectral region of the optical signal.

Thanks to the electrically conducting material and the insulating material having the same refractive index, a uniform real part of the refractive index of the electrode layer based on material properties of the electrode layer is seen by the optical signal in the active layer. This implies that the arrangement of different materials in the electrode layer does not affect the optical signal in the active layer.

It should be realized that the electrically conducting material and the insulating material need not necessarily have the same refractive index. Further, even though the electrically conducting material and the insulating material may not have the same refractive index, the differences in refractive indices may not affect the optical signal in the active layer. For instance, if the size of the electrodes is very small in relation to the wavelength of the optical signal, such as smaller than a quarter of a wavelength, the optical signal may experience a uniform average refractive index of the electrode layer.

The metamaterial may for instance comprise indium gallium zinc oxide (IGZO) forming the electrically conducting material in a silicon nitride insulating material. This may be used for ensuring that the refractive index of the electrically conducting material matches the refractive index of the insulating material.

According to an alternative, the electrically conducting material may be formed by metal vias arranged in an insulating material formed by silicon. This may be useful for modulation of optical signals having a wavelength larger than 1300 nm.

According to yet another alternative, the electrically conducting material may be formed by titanium nitride arranged in an insulating material formed by silicon.

According to an embodiment, the portions of the electrically conducting material extend through a thickness of the electrode layer.

This implies that the electrical signal may be provided to the electrodes through a connection at a first surface of the electrode layer facing away from the active layer. Further, the electrically conducting material may end at a second surface of the electrode layer facing the active layer for controlling an electrical signal in the active layer. This provides a simple manner for providing the electrical signal to the electrodes and providing a strong local effect on the electrical signal the active layer.

According to an embodiment, the electrodes of the plurality of electrodes are regularly arranged in an array with a pitch of electrodes in the array smaller than 200 nm, such as smaller than 100 nm.

The pitch of the electrodes corresponds to a distance between a center of an electrode and a center of a neighboring electrode. The pitch of the electrodes may be adapted to a wavelength of the optical signal. The pitch of the electrodes may preferably be smaller than half of the wavelength of the optical signal, such as smaller than a quarter of the wavelength.

By having a pitch of the electrodes being smaller than 200 nm, such as smaller than 100 nm, the device may be adapted for providing accurate modulation of the optical signal being in a visible range. However, if the device is to be used for optical signals of infrared light, the pitch of the electrodes may be larger.

According to an embodiment, the active layer is configured to propagate the optical signal along the extension of the active layer, wherein the active layer forms a core of a waveguide and the electrode layer forms a cladding of the waveguide.

Thus, the active layer may be configured to propagate the optical signal in a plane of the active layer. The local modulation of gain of the optical signal in the active layer may be used for controlling a variation of gain through the active layer in which the optical signal is propagated, such that the local gain variation provides a desired effect on the optical signal.

The electrode layer may provide a suitable refractive index in relation to the active layer such that the optical signal may propagate through total internal reflection in the active layer. The electrode layer and the active layer may further provide low extinction coefficients such that low losses of the optical signal occur during propagation of the optical signal in the active layer.

The active layer may form a slab waveguide having a large extension in the plane of the active layer.

However, the optical signal may alternatively be configured to be output as distributed beam or wavefront from a surface of the active layer. The modulation of the optical signal may thus provide modulation of different spatial parts of the optical signal.

According to an embodiment, a thickness of the electrode layer is at least 100 nm.

The electrode layer may be arranged between a substrate and the active layer. In some embodiments, the substrate may be configured to absorb the wavelength of the optical signal. In such case, the thickness of the electrode layer may need to be relatively large so as to prevent absorption of the optical signal in the substrate. For instance, the electrode layer may need to be larger than 500 nm such that the optical signal propagating in the active layer does not escape the cladding of the waveguide provided by the electrode layer.

However, in other embodiments, the substrate may be formed from a material that is transparent to the wavelength of the optical signal, such as a glass substrate for an optical signal in the visible range. In such case, the electrode layer need not be as thick, and the thickness of the electrode layer may for instance be as small as 100 nm.

According to an embodiment, the electrode layer is configured to be controlled for defining a gain pattern in the active layer based on a combination of local modulations by the plurality of electrodes.

Thus, a pattern of variation of gain within the active layer may be defined using the electrical signals provided to the plurality of electrodes of the electrode layer. The gain pattern may provide accurate control of modulation of the optical signal.

For instance, if the device is configured for propagating the optical signal in the active layer, the gain pattern may be used for providing optical feedback in the active layer so as to provide optical resonance in the optical layer. This may be used for operating the device to output laser light.

Thanks to the electrodes being separated by a small distance, the gain pattern may be accurately controlled with high spatial resolution in the active layer. The arrangement of the electrodes may be configured to meet the Shannon criterion. Thus, the distance between neighboring electrodes may be smaller than half of the smallest wavelength of the optical signal, which according to the Shannon criterion implies that optical resonance for the wavelength range of the optical signal may be fully controlled by controlling the gain pattern in the active layer with the spatial resolution defined by the distances between neighboring electrodes.

According to an embodiment, the electrode layer is a first electrode layer and the device further comprises a second electrode layer, wherein the active layer is formed between the first electrode layer and the second electrode layer, wherein the plurality of electrodes of the first electrode layer are configured to selectively receive a first electrical signal and the second electrode layer is configured to receive a second electrical signal, wherein the first and second electrical signals may have opposite polarity.

Thus, the active layer may be sandwiched between the first and the second electrode layers. The first electrical signal and the second electrical signal provided to the first electrode layer and the second electrode layer, respectively, are configured to cause a locally controlled electrical signal in the active layer between the first and the second electrode layers for providing local modulation of the optical signal.

The second electrode layer may define a large-size electrode, such that the plurality of electrodes in the first electrode layer may all be related to a common, single second electrode. This implies that a single, second electrical signal may be provided to the second electrode of the second electrode layer. The plurality of electrodes in the first electrode layer may however receive individually controlled electrical signals, such that different first electrical signals are provided to different electrodes of the plurality of electrodes in the first electrode layer.

According to an alternative, the second electrode layer may also comprise a plurality of electrodes. Thus, the device may comprise a plurality of pairs of electrodes, wherein each pair is defined by one electrode in the first electrode layer and one electrode in the second electrode layer. The electrodes in a pair may be arranged to be aligned with each other, such that the electrode in the first electrode layer may be arranged around a first symmetry axis extending through the first layer and the electrode in the second electrode layer may be arranged around a second symmetry axis extending through the second layer, wherein the first and second symmetry axes are collinear. By defining pairs of electrodes in the first and second electrode layers the electrical signals to each of the electrodes in the pair may be individually controlled irrespective of electrical signals to other pairs of electrodes. This may provide a free control of the electrical signal in the active layer.

The electrical signal in the active layer may thus be defined between electrodes arranged on opposite sides of the active layer. This implies that the electrical signal may be defined through the entire thickness of the active layer and that the electrical signal is uniformly provided in a cross-section of the active layer. For instance, the first and second electrical signals may cause an electric field to be defined within the active layer, wherein the electric field may be uniform in a local cross-section of the active layer associated with one electrode of the plurality of electrodes of the first electrode layer.

The first and second electrical signals may have different polarity for setting different electric potentials in the first electrode layer and the second electrode layer. This may be a convenient manner of controlling the electrical signal in the active layer. However, it should be realized that the first and second electrical signals may alternatively be set to different levels for defining an electrical signal in the active layer, wherein the levels of the first and second electrical signals may or may not have a same polarity. Further, the first and second electrical signals may be set to a same level, which may be non-zero, when no impact on the active layer in a particular location is desired.

The second electrode layer may be configured to extend along the active layer such that a surface of the electrode layer extends over an area corresponding to a surface of the active layer. The surface of the second electrode layer may have a shape conforming to a shape of the active layer. For instance, the active layer and the second electrode layer may both be planar and may be arranged to extend in parallel planes.

The second electrode layer may be configured as a homogeneous layer forming a single, second electrode. Alternatively, if the second electrode layer comprises a plurality of electrodes, the second electrode layer may be formed by electrically conducting material forming the electrodes, wherein the electrically conducting material is surrounded by insulating material for separating neighboring electrodes.

The second electrode layer may thus be formed from a suitable material for providing desired optical properties of the second electrode layer. If the second electrode layer comprises a plurality of electrodes, the second electrode layer may be formed in a same manner as the first electrode layer described above. If the second electrode layer is a homogeneous layer, the second electrode layer may be formed by a material providing suitable optical properties.

For instance, the second electrode layer may form a cladding of a waveguide, such that the active layer may form a core of a waveguide between the first and second electrode layers, which form claddings of the waveguide. The second electrode layer may thus have a refractive index adapted to ensure that the optical signal is guided in the active layer through total internal reflection.

Alternatively, the device may be configured to output an optical signal through a surface of the active layer. The optical signal may thus pass through the second electrode layer. In such case, the second electrode layer may be configured to be transparent to the optical signal so as not to affect the optical signal being passed therethrough. It should also be realized that the device may be configured to receive incident light for triggering generation of the optical signal in the active layer. Such incident light may also be received through the second electrode layer, which may thus be configured to be transparent to the incident light for triggering generation of the optical signal. The second electrode layer may for instance be formed by indium tin oxide.

According to another embodiment, the electrodes in the plurality of electrodes comprise a first set of electrodes and a second set of electrodes, wherein electrodes of the first set of electrodes are alternatingly arranged with electrodes of the second set of electrodes, wherein the electrodes of the first set of electrodes are configured to selectively receive a first electrical signal and the electrodes of the second set of electrodes are configured to selectively receive a second electrical signal, wherein the first and second electrical signals have opposite polarity.

This implies that the device need only include an electrode layer at one side of the active layer. Hence, the device may be freely designed on the other side of the active layer to provide desired optical properties.

Neighboring electrodes may be provided with different electrical signals so as to cause a locally controlled electrical signal in the active layer between the neighboring electrodes. Each electrode may be configured to be provided with an individually controlled electrical signal, which may further be controlled in an analog manner. For instance, the electrical signal may be freely controlled within a range of values.

However, thanks to defining a first set of electrodes and a second set of electrodes, the control of the electrical signals to be provided to the electrodes may be simplified. Thus, each electrode of the first set may be configured to selectively receive the first electrode signal and each electrode of the second set may be configured to selectively receive the second electrical signal. This implies that the electrical signal to each of the electrodes may be selectively turned on or off for controlling whether local modulation of gain in the active layer is to be provided or not.

Thanks to alternatingly arranging the electrodes of the first set and the electrodes of the second set, neighboring electrodes will belong to different sets of electrodes. The first and second sets of electrodes may be regularly arranged in a two-dimensional array, wherein each electrode in the first set is surrounded by four electrodes in the second set along rows and columns in the array, and vice versa.

The first and second electrical signals may have different polarity for setting different electric potentials at the electrodes in the first set and at neighboring electrodes in the second set. This may be a convenient manner of controlling the electrical signal in the active layer. However, it should be realized that the first and second electrical signals may alternatively be set to different levels for defining an electrical signal in the active layer, wherein the levels of the first and second electrical signals may or may not have a same polarity.

The electrical signal in the active layer between two neighboring electrodes is controlled by the electrical signals provided to the electrodes. Since the electrodes are arranged in the same electrode layer, the electrical signal in the active layer may be stronger at a surface of the active layer facing the electrode layer compared to the electrical signal close to an opposite surface of the active layer. This implies that local modulation of gain in the active layer may be predominantly provided at or close to the surface of the active layer facing the electrode layer.

For instance, the first and second electrical signals may cause an electric field to be defined within the active layer, wherein a fringing electric field may be provided in a local cross-section of the active layer between the neighboring electrodes.

According to an embodiment, the device is configured to control gain in the active layer for controlling amplification of the optical signal, such as providing optical feedback for forming a laser signal, and/or for controlling beam steering of the optical signal output by the device or a three-dimensional pattern formed by the optical signal output by the device.

The local variation of gain in the active layer may be utilized in many different manners and the device may thus be used in different applications.

The device may be suitably used for controlling amplification of an optical signal in the active layer. This may be used for providing amplified stimulated emission of light, such as operating the device to provide a laser signal.

The device may be used for controlling beam steering such that the device may be used for controlling a direction of output of an optical signal from the device. This may be used in many different applications.

The device may also be used for controlling a three-dimensional pattern formed by the optical signal. Thus, the device may be used for controlling a three-dimensional light field, controlling amplitude and phase of light in three dimensions. This may for instance be used for display of holographic images.

According to an embodiment, the active layer is formed by a material providing active output of light based on receiving an incident light signal and/or electrical signal and controlled by the electrical signal in the active layer. Thus, the active layer may receive incident light and/or an electrical signal for triggering generation of the optical signal in the active layer. The active layer may further provide a gain medium for amplifying the optical signal generated in the active layer.

The active layer may for instance comprise an organic material, quantum dots, perovskite crystals, or III-V semiconductors.

According to a second aspect, there is provided a method for modulation of an optical signal, said method comprising: generating the optical signal in an active layer; controlling an electrical signal provided to each of a plurality of separate electrodes in an electrode layer arranged to extend along the active layer, wherein the electrode layer comprises a plurality of separate electrodes associated with respective parts of the active layer, wherein each electrode of the plurality of electrodes have a size of a cross-section in the electrode layer smaller than a wavelength of the optical signal and neighboring electrodes are separated by a distance smaller than the wavelength of the optical signal, wherein the electrical signal provided to each of the plurality of separate electrodes locally modulates an imaginary part of a refractive index of the active layer by locally controlling an electrical signal in the active layer.

Effects and features of this second aspect are largely analogous to those described above in connection with the first aspect. Embodiments mentioned in relation to the second aspect are largely compatible with the first aspect.

Thanks to the method, a local control of gain in the active layer may be provided, such that accurate modulation of the optical signal may be provided. The method may be used for modulating amplitude, phase and/or wavelength of the optical signal. This may for instance be used for controlling beam steering (direction) of the optical signal, for controlling a three-dimensional light field output by the device (for controlling a holographic image), and/or for providing optical processing of data.

### Brief description of the drawings

The above, as well as additional objects, features, and advantages of the present description, will be better understood through the following illustrative and non-limiting detailed description, with reference to the appended drawings. In the drawings like reference numerals will be used for like elements unless stated otherwise.
Fig. 1 is a schematic view of a device according to a first embodiment.
Fig. 2 is a schematic view of a local electrical signal in an active layer of the device in Fig. 1.
Fig. 3 is a schematic view of a device according to a second embodiment.
Fig. 4 is a schematic view of a local electrical signal in an active layer of the device in Fig. 3.
Fig. 5 is a flow chart of a method according to an embodiment.

### Detailed description

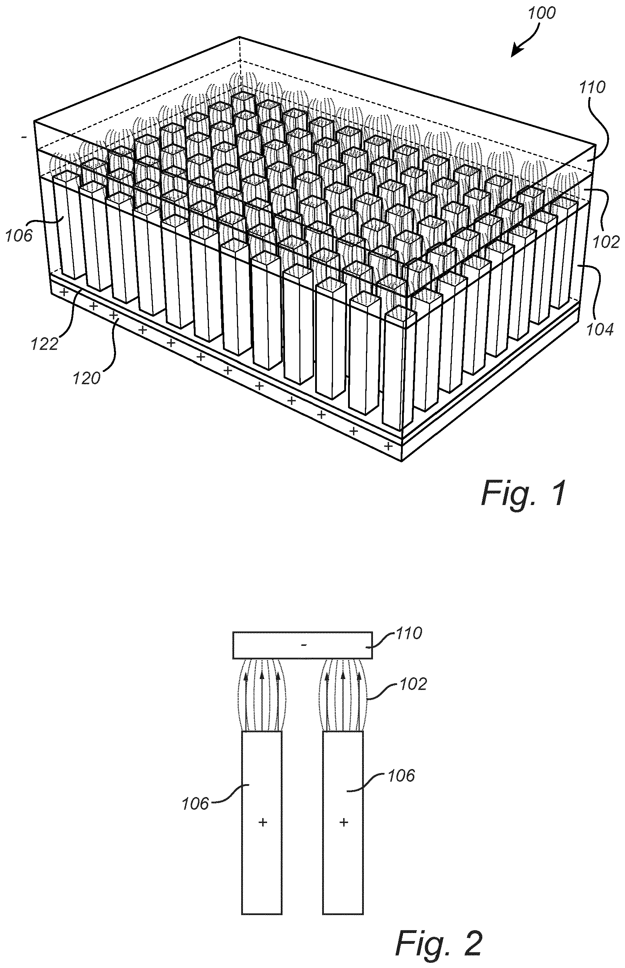

Referring now to Fig. 1, a device 100 for modulation of an optical signal according to a first embodiment will be described.

The device 100 may comprise an active layer 102. The active layer may comprise two opposite surfaces defining interfaces of the active layer 102. The active layer 102 may have a large extension in a direction along the surfaces. The active layer 102 may further have a relatively small thickness between the opposite surfaces, such that the extension of the surfaces is much larger than the thickness of the active layer 102.

The active layer 102 may have a uniform thickness over the entire extension of the active layer 102. The active layer 102 may further be planar. Thus, the active layer may be configured to extend in a plane. This may provide for a simple manufacturing of the active layer 102. For instance, the active layer 102 may be formed by deposition of a material on a structure below the active layer 102, such as by thin film deposition. However, it should be realized that the active layer 102 may not necessarily have a uniform thickness and/or be planar.

The active layer 102 may comprise a material for providing an active emission of light in the active layer 102. The active layer 102 may thus be configured to emit light based on incident light being received in the active layer 102. The active layer 102 may be configured to provide a gain of an optical signal that is generated in the active layer 102.

The active layer 102 may provide active emission of light by the active layer 102 comprising an organic material, such as aluminum tris(guinolate) (Alq3), polyphenylene vinylene (PPV) derivatives, (4-(dicyanomethylene)-2-methyl-6-(4-dimethylaminostyryl)-4H-pyran (DCM), (poly(9,9'-dioctylfluorene-co-benzothiadiazole)) (FBBT), or (poly(2-methoxy-5-(2-ethyl-hexyloxy)-1,4-phenylene-vinylene) (MEH-PPV), quantum dots, such as CdSe/Cd1-xZnxSe/ZnSe0.5S0.5/ZnSI, perovskite structures, such as CsPbIxBr3-x, methylammonium lead iodide (MAPI), or formamidinium lead iodide (FAPI) or III-V semiconductor., such as GaAlAs, InGaAs, InGaN, GaN, or InGaAlP

The active layer 102 may be configured to provide electrically controlled gain of the optical signal. Thus, an electrical signal in the active layer 102 may affect the gain of the optical signal, such that modulation of the optical signal may be controlled in the device 100.

A thickness of the active layer 102 may be dependent on a desired gain of the optical signal in the active layer 102. The active layer may have a thickness of at least 50 nm, such as a thickness in a range of 50-150 nm.

The device 100 further comprises a first electrode layer 104 and a second electrode layer 110. The first and second electrode layers 104, 110 are arranged to extend along an extension of the surfaces of the active layer 102. The first electrode layer 104 and the second electrode layer 110 may be arranged on opposite sides of the active layer 102 such that the active layer 102 is arranged between the first electrode layer 104 and the second electrode layer 110.

The first electrode layer 104, the active layer 102 and the second electrode layer 110 may thus be arranged in a stack, wherein each layer is planar, and the layers are arranged to extend in parallel planes.

The first electrode layer 104 may comprise a plurality of separate electrodes 106. The plurality of separate electrodes 106 may be distributed over the extension of the first electrode layer 104. Thus, each electrode 106 may be associated with a respective part of the active layer 102, such that different electrodes 106 are associated with different parts of the active layer 102.

The second electrode layer 110 may be formed as a single electrode extending over the entire extension of the second electrode layer 110. However, the second electrode layer 110 may alternatively comprise a plurality of separate electrodes. Electrical signals may be provided to the electrodes of the first electrode layer 104 and to the electrode(s) of the second electrode layer 110. These electrical signals may serve to control an electrical signal in the active layer 102 between the first electrode layer 104 and the second electrode layer 110.

As illustrated in Fig. 2, the electrical signal in the active layer 104 may be locally controlled. Each electrode 106 in the plurality of electrodes in the first electrode layer 104 may control the electrical signal in the active layer 102 in the part of the active layer 102 associated with the electrode 106. The electrical signal in the active layer 102 may be defined by the electrical signal provided to the electrode 106 and the electrical signal provided to the second electrode layer 110.

The electrical signal in the active layer 102 (also illustrated as shaded patterns associated with each of the electrodes 106 in Fig. 1) may be defined by electrical signals on electrodes on opposing sides of the active layer 102. However, the electrodes 106 in the first electrode layer 104 may provide an electrical signal in relation to a shared electrode in the second electrode layer 110, for instance a single electrode extending over the entire second electrode layer 110.

The local control of an electrical signal in the active layer 102 may thus be dependent on the electrical signals provided to the electrodes of the first electrode layer 104. However, the second electrode layer 110 may alternatively comprise a plurality of electrodes. In such case, a plurality of pairs of electrodes may be defined, wherein each pair comprises a unique electrode in the first electrode layer 104 and a unique electrode in the second electrode layer 110 arranged opposite to the electrode in the first electrode layer 104. This implies that the control of the electrical signal in the active layer 102 may be based on controlling the electrical signals provided to each of the electrodes in a pair of electrodes in the first and second electrode layers 104, 110.

Thus, the locally controlled electrical signal in a part of the active layer 102 may be defined by a first electrical signal provided to the electrode 106 in the first electrode layer 104 associated with the part of the active layer 102 and by a second electrical signal provided to the second electrode layer 110, either to a shared electrode or to a unique electrode associated with the part of the active layer 102.

The first and second electrical signals may for instance be a voltage signal or a current signal. The first and second electrical signals may have different levels for defining an electrical signal in the active layer 102. For instance, the first and second electrical signals may have different polarity, but it should be realized that the first and second electrical signals may have the same polarity but different levels.

The first and second electrical signals may locally control the electrical signal in the active layer 102. The electrical signal in the active layer 102 may for instance be an electric field in the active layer 102 or charge carriers injected into the active layer 102.

The electrical signal in the active layer 102 may be defined between electrodes arranged on opposite sides of the active layer 102. This implies that the electrical signal may be defined through the entire thickness of the active layer 102 and that the electrical signal is uniformly provided in a cross-section of the active layer 102.

The local control of the electrical signal in the active layer 102 provides a local modulation of an imaginary part of a refractive index of the active layer 102. The imaginary part of the refractive index may also be referred to as an optical extinction coefficient and is related to loss of the optical signal in the active layer 102. This implies that an optical gain of the active layer 102 may be locally modulated. For instance, the active layer 102 may be configured to provide a gain (amplification) of the optical signal if a high electric field is provided in the active layer 102, whereas the active layer 102 may provide lower or no gain if no or a small electric field is provided in the active layer 102.

In embodiments, the local control of the electrical signal in the active layer 102 may be used for providing an optical gain coefficient of 250 cm⁻¹, which corresponds to an optical extinction coefficient of -1.2.10⁻³.

The electrical signals provided to the electrodes 106 in the first electrode layer 104 may be controlled for controlling the local modulation of the optical signal in the active layer 102. Each electrode 106 may receive an individually controlled electrical signal. However, it should be realized that some electrodes may be connected to receive the same electrical signals.

The local control of modulation of the optical signal may be used for controlling modulation of the optical signal by the device 100. The device 100 may be configured to receive an incident light signal through a surface along the extension of the active layer 102 for triggering generation of the optical signal in the active layer 102. The local modulation of the optical signal in the active layer 102 may provide spatially distributed modulation of the optical signal, such that different parts of the optical signal are provided with different modulations. This may be used for instance to control a shape of a wavefront of an optical signal. The optical signal output by the device 100 may be provided at an opposite surface to the surface through which the incident light is provided or may be output through the same surface.

According to another embodiment, the optical signal may be propagated in the plane of the active layer 102 along the extension of the active layer 102. The active layer 102 may thus form a core of a waveguide and the electrode layers 104, 110 may form claddings of the waveguide. The active layer 102 may have a large extension such that a slab waveguide is defined.

The local modulation of the optical signal may thus be configured to define a gain pattern in the active layer 102 based on a combination of local modulations by the plurality of electrodes 106 in the first electrode layer 104. The gain pattern may provide control of the modulation of the optical signal. For instance, a periodicity of local modulations in the gain pattern may be used for providing a combined effect by the gain pattern on the optical signal. Thus, the gain pattern may be controlled to ensure optical resonance of the optical signal being propagated through the active layer 102 or for generating or controlling modes of the optical signal in the active layer 102.

The gain pattern may be tuned so as to tune a periodicity of local modulations. This may be used for controlling or changing direction of the optical signal being outcoupled by the active layer 102. The device 100 may be configured to modulate amplitude, phase and/or wavelength of the optical signal.

The plurality of electrodes 106 in the first electrode layer 104 may be controlled to selectively receive a first electrical signal. Thus, the electrical signal provided to the electrodes may be selectively turned on or off. This provides a simple manner of providing a gain variation in the active layer. However, it should be realized that the first electrical signal may alternatively be controlled between multiple set levels or analog control within a range of values may be provided. This provides further accuracy in controlling the gain variation in the active layer but may also require more complex control circuitry for providing the electrical signals to the electrodes 106.

The first electrode layer 104 may have small features providing an accurate control of the local modulation of gain in the active layer 102. The electrodes 106 have a characteristic dimension of a cross-section of the electrodes 106 in a plane of the first electrode layer 104 that is smaller than a wavelength of the optical signal in the active layer 102. Thus, the size, such as diameter or width, of the cross-section of the electrodes 106 may be smaller than the wavelength. In addition, a distance between neighboring electrodes 106 is smaller than the wavelength of the optical signal.

The electrodes 106 may preferably have a characteristic dimension that is smaller than half of the wavelength of the optical signal or even smaller than a quarter of the wavelength of the optical signal. In addition, the distance between neighboring electrodes 106 may also be smaller than half of the wavelength of the optical signal, or smaller than a quarter of the wavelength of the optical signal.

The plurality of electrodes 106 may be regularly arranged in the first electrode layer 104. This implies that the gain variation in the active layer 102 may be controlled with a same resolution throughout the active layer 102. The plurality of electrodes 106 may be arranged in a one-dimensional or two-dimensional array.

A pitch, i.e., a distance between a center of an electrode and a center of a neighboring electrode, of the array may be smaller than the wavelength of the optical signal, such as smaller than half of the wavelength of the optical signal or even smaller than a quarter of the wavelength of the optical signal. For instance, the pitch of the electrodes 106 in the array may be smaller than 200 nm, or even smaller than 100 nm. This may be suitable for modulation of an optical signal of visible light.

The electrodes 106 may be formed to extend through the thickness of the first electrode layer 104. This implies that the electrodes 106 may be provided at a surface of the first electrode layer 104 facing the active layer 102 so as to facilitate control of the electrical signal in the active layer 102. Further, electrical connections may be provided to the electrodes 106 at the opposing surface facing away from the active layer 102 for providing the electrical signal to the electrodes 106 at the surface facing away from the active layer 102.

The electrodes 106 may be formed by an electrically conducting material, which may be surrounded by an electrically insulating material for separating the electrodes 106 from each other.

The electrically conducting material and the electrically insulating material may have a same refractive index. This implies that there is no variation of the refractive index in the first electrode layer 104, such that the optical signal is not affected by a variation of the refractive index in the first electrode layer 104. Hence, local variation of effects on the optical signal in the active layer 102 may be caused only by the local control of the electrical signal in the active layer.

According to an embodiment, the first electrode layer 104 may comprise indium gallium zinc oxide (IGZO) forming the electrically conducting material in a silicon nitride insulating material. This may be used for ensuring that the refractive index of the electrically conducting material matches the refractive index of the insulating material.

According to another embodiment, the electrically conducting material may be formed by metal vias arranged in an insulating material formed by silicon. This may be useful for modulation of optical signals having a wavelength larger than 1300 nm.

According to yet another embodiment, the electrically conducting material may be formed by titanium nitride arranged in an insulating material formed by silicon.

According to an embodiment, the first electrode layer 104 may be formed as a metamaterial comprising the electrically conducting material forming the electrodes 106 and the electrically insulating material between the electrodes 106.

The device 100 may use the electrodes in order to provide a purely electrical control of the optical signal in the active layer 102. Thus, modulation of the optical signal may be provided based on the locally controlled electrical signal in the active layer 102.

However, the device 100 may alternatively use the electrical control together with an optical control. Thus, the active layer 102 may be homogeneously optically pumped in order to reduce an extinction coefficient of the active layer 102. In addition, the electrical signals to the electrodes locally provide additional electrical pumping of the active layer 102 to add excited states in parts of the active layer 102 associated with the respective electrodes, so as to create a gain pattern based on the electrical signals to the electrodes.

Thus, the device 100 may provide modulation of an optical signal based on the optical pumping and the electrical pumping of the active layer 102. The optical pumping of the active layer 102 may be sufficiently strong to generate gain in the active layer 102, but the optical pumping may alternatively be at a level below generating gain in the active layer 102.

As yet another alternative, the active layer 102 may be homogeneously optically pumped above a threshold for amplified stimulated emission of light. In such case, the electrical signals to the electrodes provide a negative gain pattern in order to locally define parts of active layer 102 with a reduced gain.

The device 100 may be used in various applications for controlling an optical signal. The device 100 may be used for controlling propagation of the optical signal in the active layer 102, for instance by controlling modes within the active layer 102. This may be used in a photonic integrated circuit, wherein the device 100 may for instance be used for controlling a path taken by the optical signal. The device 100 may even be used in an optical processing unit, wherein one or more optical signals may be controlled, such as controlling ports to which the optical signals are transferred. The device 100 may also be configured to control a superpositioned state of a plurality of optical signals in the active layer 102.

The device 100 may be used for controlling amplification of the optical signal in the active layer. This may be used for providing an amplifier for amplifying an optical signal. It may also be used for operating the device 100 to generate a laser signal.

The device 100 may be configured to output the optical signal at an edge of the active layer 102. The optical signal may be modulated by the device 100 to control a direction, amplitude, phase and/or wavelength of the optical signal output by the device.

The device 100 may alternatively be configured to output the optical signal through a surface along the extension of the active layer 102. The device 100 may for instance control the optical signal for output of second order or higher modes of the optical signal from the active layer 102. The device 100 may be controlled for controlling a variation of an emission pattern of the output optical signal. This may be used for instance for controlling beam steering of the optical signal output by the device or for controlling a three-dimensional pattern formed by the optical signal, such as for providing a holographic display.

The device 100 may further comprise a substrate 120, which may carry the electrode layers 104, 110 and the active layer 102. The substrate 120 may be provided in form of a silicon substrate, which may also provide integrated circuitry for controlling the electrical signals to be provided to the electrodes.

For instance, control circuitry 122 may be provided on or in the substrate 120. The control circuitry 122 may be provided in relation to each of the electrodes 106 of the first electrode layer 104 such that the control circuitry for controlling the electrical signal to be provided to respective electrodes 106 may be provided below the respective electrode 106 in a corresponding location on or in the substrate 120. Thus, the control circuitry 122 may be directly connected to the electrodes 106.

According to an alternative, electrical connections, such as electrical lines, may be provided in a layer extending along the first electrode layer 104. The electrical connections may be connected to control circuitry for controlling the electrical signals provided to the electrodes 106, such that the control circuitry need not be arranged immediately below the respective electrodes 106. This may imply that a size of the control circuitry is not limited to the pitch of the electrodes 106.

Each electrode 106 may be associated with an individual control circuitry. This implies that the electrical signal provided to each electrode may be individually controlled.

The control circuitry 122 may be configured to output an electrical signal that may be controlled in an analog manner. This implies that a level of the electrical signal may be freely varied within a range of values.

According to an embodiment, the control circuitry 122 may be configured to selectively provide the electrical signal to the electrode 106. Thus, the output of an electrical signal from the control circuitry 122 may be selectively turned on or off. This may facilitate simple control of the electrical signals provided to the electrodes 106.

For instance, the control circuitry 122 may comprise memory elements, such that each individual control circuitry is provided by a memory element. The memory element may be connected to the electrode 106 for output of the electrical signal. Thus, by reading a bit into the memory element, the memory element may be controlled to selectively turn on or off the electrical signal to the electrode 106 connected to the memory element.

Each memory element may be formed by a dynamic random-access memory (DRAM) cell. The size of the memory cells may be very small, such that the DRAM cells may be arranged in area of the substrate 120 associated with the respective electrodes 106.

The substrate 120 may be formed in silicon providing a possibility to integrate the control circuitry 122 on the substrate 120 using conventional semiconductor processing. However, silicon absorbs light in the visible range. The first electrode layer 104 may have a relatively large thickness to avoid that the optical signal propagating in the active layer 102 is affected by the silicon substrate 120. Thus, the first electrode layer 104 may have a thickness of at least 500 nm.

However, the substrate 120 may alternatively be formed in a different material, such as using glass which may be transparent to the optical simples. In such case, the first electrode layer 104 may not need to have a large thickness and the first electrode layer 104 may for instance have a thickness of at least 100 nm.

The second electrode layer 110 may be connected to receive the second electrical signal. For instance, the second electrode layer 110 may be connected to the control circuitry 122 for receiving the second electrical signal. The second electrode layer 110 may be formed as a single electrode extending over the entire extension of the second electrode layer 110. Thus, the second electrical signal may be provided by a single connection to the control circuitry 122. For instance, the connection to the second electrode layer 110 may be provided at a side or edge of the second electrode layer 110.

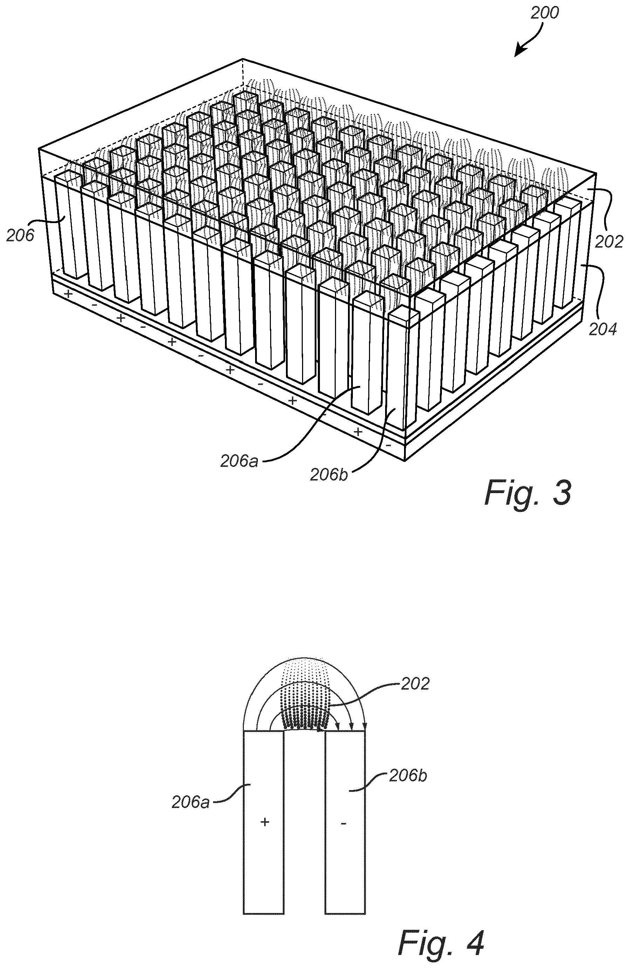

Referring now to Fig. 3, a device 200 for modulation of an optical signal according to a second embodiment will be described. The device 200 corresponds to the device 100 of the first embodiment described above, except that the device 200 only comprises one electrode layer 204.

The device 200 may comprise an active layer 202, a substrate 220 with control circuitry 222 as described above for the first embodiment. For brevity, only the differences between the first and second embodiments will be described below.

The electrode layer 204 may be configured to extend below the active layer 202, such that the electrode layer 204 is arranged between the substrate 220 and the active layer 202. The electrode layer 204 comprises a plurality of electrodes 206. The electrodes 206 may receive electrical signals for controlling an electrical signal in the active layer 202.

Neighboring electrodes 206 may receive different electrical signals. Thus, as illustrated in Fig. 4, the locally controlled electrical signal in a part of the active layer 102 between two neighboring electrodes 206 may be defined by a first electrical signal provided to one of the electrodes and by a second electrical signal provided to the other of the electrodes

The first and second electrical signals may for instance be a voltage signal or a current signal. The first and second electrical signals may have different levels for defining an electrical signal in the active layer 102 between the neighboring electrodes. For instance, the first and second electrical signals may have different polarity, but it should be realized that the first and second electrical signals may have the same polarity but different levels.

The first and second electrical signals may locally control the electrical signal in the active layer 202 (also illustrated as shaded patterns associated with each pair of neighboring electrodes 206 in Fig. 3). The electrical signal in the active layer 202 may for instance be an electric field in the active layer 202 or charge carriers injected into the active layer 202.

For instance, the first and second electrical signals may cause an electric field to be defined within the active layer 202, wherein a fringing electric field may be provided in a local cross-section of the active layer 202 between the neighboring electrodes.

The plurality of electrodes 206 may be divided into a first set of electrodes and a second set of electrodes. The electrodes 206a of the first set of electrodes may be alternatingly arranged with the electrodes 206b of the second set of electrodes.

The electrodes 206a of the first set of electrodes may be configured to selectively receive a first electrical signal and the electrodes 206b of the second set of electrodes may be configured to selectively receive a second electrical signal.

Each of the electrodes may be individually controlled to selectively control whether the electrode receives an electrical signal. However, the electrodes 206a of the first set of electrodes may be configured to selectively receive a first electrical signal, i.e., the control circuitry 222 associated with an electrode 206a of the first set of electrodes may be configured to select whether to turn on or off the first electrical signal to the electrode 206a. Similarly, the electrodes 206b of the second set of electrodes may be configured to selectively receive a second electrical signal, i.e., the control circuitry 222 associated with an electrode 206b of the second set of electrodes may be configured to select whether to turn on or off the second electrical signal to the electrode 206b.

The first and second electrical signals may have opposite polarity, such that an electrical signal in the active layer 202 may be defined based on the neighboring electrodes receiving different electrical signals.

The device 200 according to the second embodiment may be configured to be controlled for providing corresponding effects on the optical signal as described above for the device 100 according to the first embodiment.

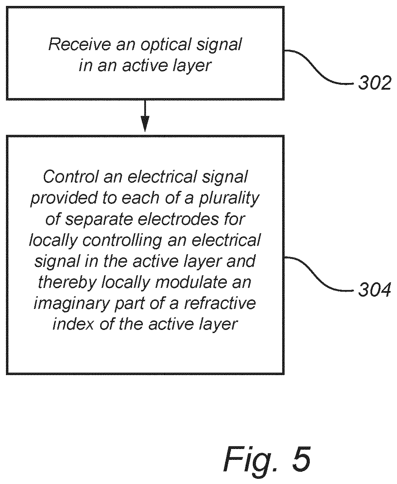

Referring now to Fig. 5, a method for modulation of an optical signal will be described.

The method comprises generating 302 the optical signal in an active layer. The optical signal may be generated based on an incident light signal and/or an electrical signal in the active layer.

The method further comprises controlling 304 an electrical signal provided to each of a plurality of separate electrodes in an electrode layer arranged to extend along the active layer.

The electrode layer comprises a plurality of separate electrodes associated with respective parts of the active layer, wherein each electrode of the plurality of electrodes has a size of a cross-section in the electrode layer smaller than a wavelength of the optical signal and neighboring electrodes are separated by a distance smaller than the wavelength of the optical signal.

The electrical signal provided to each of the plurality of separate electrodes locally modulates an imaginary part of a refractive index of the active layer by locally controlling an electrical signal in the active layer.

The method may comprise controlling the electrical signal in the active layer by controlling electrical signals provided to neighboring electrodes in the electrode layer so as to control the electrical signal in the active layer between the neighboring electrodes.

Alternatively, the method may comprise controlling the electrical signal in the active layer by controlling the electrical signal in an electrode in the electrode layer in relation to an electrical signal provided to another electrode layer arranged on an opposite side of the active layer. Thus, the electrical signal in the active layer may be controlled based on electrical signals to electrodes provided on opposite sides of the active layer.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A device (100; 200) for modulation of an optical signal, said device comprising:
an active layer (102; 202) configured to provide electrically controlled gain of the optical signal;
an electrode layer (104; 204) arranged to extend along the active layer (102; 202), wherein the electrode layer (104; 204) comprises a plurality of separate electrodes (106; 206a, 206b) associated with respective parts of the active layer (102; 200), wherein each electrode (106; 206a, 206b) of the plurality of electrodes have a size of a cross-section in the electrode layer (104; 204) smaller than a wavelength of the optical signal and neighboring electrodes are separated by a distance smaller than the wavelength of the optical signal; wherein an electrical signal to each of the plurality of separate electrodes (106; 206a, 206b) is controllable for locally modulating an imaginary part of a refractive index of the active layer (102; 202) by locally controlling an electrical signal in the active layer (102; 202).

2. The device according to claim 1, wherein each electrode (106; 206a, 206b) is associated with an individual control circuitry for controlling the electrical signal provided to the electrode (106; 206a, 206b).

3. The device according to claim 1 or 2, wherein the electrical signal to each of the plurality of separate electrodes (106; 206a, 206b) is selectively turned on or off.

4. The device according to any one of the preceding claims, wherein the electrode layer (104; 204) is formed by a metamaterial comprising an electrically conducting material and an insulating material, wherein portions of the electrically conducting material form the plurality of separate electrodes (106; 206a, 206b).

5. The device according to claim 4, wherein the electrically conducting material and the insulating material have a same refractive index.

6. The device according to claim 4 or 5, wherein the portions of the electrically conducting material extend through a thickness of the electrode layer (104; 204).

7. The device according to any one of the preceding claims, wherein the electrodes of the plurality of electrodes (106; 206a, 206b) are regularly arranged in an array with a pitch of electrodes (106; 206a, 206b) in the array smaller than 200 nm, such as smaller than 100 nm.

8. The device according to any one of the preceding claims, wherein the active layer (102; 202) is configured to propagate the optical signal along the extension of the active layer (102; 202), wherein the active layer (102; 202) forms a core of a waveguide and the electrode layer (104; 204) forms a cladding of the waveguide.

9. The device according to any one of the preceding claims, wherein a thickness of the electrode layer (104; 204) is at least 100 nm.

10. The device according to any one the preceding claims, wherein the electrode layer (104; 204) is configured to be controlled for defining a gain pattern in the active layer (102; 202) based on a combination of local modulations by the plurality of electrodes (106; 206a, 206b).

11. The device according to any one of the preceding claims, wherein the electrode layer is a first electrode layer (104) and the device further comprises a second electrode layer (110), wherein the active layer (102) is formed between the first electrode layer (104) and the second electrode layer (110), wherein the plurality of electrodes (106) of the first electrode layer (104) are configured to selectively receive a first electrical signal and the second electrode layer (110) is configured to receive a second electrical signal, wherein the first and second electrical signals have opposite polarity.

12. The device according to any one of claims 1-10, wherein the electrodes (206) in the plurality of electrodes comprise a first set of electrodes and a second set of electrodes, wherein electrodes (206a) of the first set of electrodes are alternatingly arranged with electrodes (206b) of the second set of electrodes, wherein the electrodes (206a) of the first set of electrodes are configured to selectively receive a first electrical signal and the electrodes (206b) of the second set of electrodes are configured to selectively receive a second electrical signal, wherein the first and second electrical signals have opposite polarity.

13. The device according to any one of the preceding claims, wherein the device (100; 200) is configured to control gain in the active layer (102; 202) for controlling amplification of the optical signal, such as providing optical feedback for forming a laser signal, and/or for controlling beam steering of the optical signal output by the device (100; 200) or a three-dimensional pattern formed by the optical signal output by the device (100; 200).

14. A method for modulation of an optical signal, said method comprising:
generating (302) the optical signal in an active layer;
controlling (304) an electrical signal provided to each of a plurality of separate electrodes in an electrode layer arranged to extend along the active layer, wherein the electrode layer comprises a plurality of separate electrodes associated with respective parts of the active layer, wherein each electrode of the plurality of electrodes have a size of a cross-section in the electrode layer smaller than a wavelength of the optical signal and neighboring electrodes are separated by a distance smaller than the wavelength of the optical signal, wherein the electrical signal provided to each of the plurality of separate electrodes locally modulates an imaginary part of a refractive index of the active layer by locally controlling an electrical signal in the active layer.

## Patentansprüche

1. Vorrichtung (100; 200) zum Modulieren eines optischen Signals, wobei die Vorrichtung umfasst:
eine aktive Schicht (102; 202), die dazu konfiguriert ist, einen elektrisch gesteuerten Verstärkungsfaktor des optischen Signals bereitzustellen;
eine Elektrodenschicht (104; 204), die dazu angeordnet ist, sich entlang der aktiven Schicht (102; 202) zu erstrecken, wobei die Elektrodenschicht (104; 204) eine Vielzahl von getrennten Elektroden (106; 206a, 206b) umfasst, die jeweiligen Teilen der aktiven Schicht (102; 200) zugeordnet sind, wobei jede Elektrode (106; 206a, 206b) der Vielzahl von Elektroden eine Größe eines Querschnitts in der Elektrodenschicht (104; 204) aufweist, die kleiner als eine Wellenlänge des optischen Signals ist, und benachbarte Elektroden durch einen Abstand getrennt sind, der kleiner als die Wellenlänge des optischen Signals ist, wobei ein elektrisches Signal an jede der Vielzahl von separaten Elektroden (106; 206a, 206b) zum lokalen Modulieren eines imaginären Teils eines Brechungsindex der aktiven Schicht (102; 202) durch lokales Steuern eines elektrischen Signals in der aktiven Schicht (102; 202) steuerbar ist.

2. Vorrichtung nach Anspruch 1, wobei jede Elektrode (106; 206a, 206b) individuellen Steuerschaltungen zugeordnet ist, um das elektrische Signal zu steuern, das der Elektrode (106; 206a, 206b) bereitgestellt wird.

3. Vorrichtung nach Anspruch 1 oder 2, wobei das elektrische Signal an jede der Vielzahl von getrennten Elektroden (106; 206a, 206b) selektiv ein-oder ausgeschaltet wird.

4. Vorrichtung nach einem der vorhergehenden Ansprüche, wobei die Elektrodenschicht (104; 204) durch ein Metamaterial gebildet wird, das ein elektrisch leitendes Material und ein isolierendes Material umfasst, wobei Abschnitte des elektrisch leitenden Materials die Vielzahl von getrennten Elektroden (106; 206a, 206b) bilden.

5. Vorrichtung nach Anspruch 4, wobei das elektrisch leitende Material und das isolierende Material den gleichen Brechungsindex aufweisen.

6. Vorrichtung nach Anspruch 4 oder 5, wobei sich die Abschnitte des elektrisch leitenden Materials durch eine Dicke der Elektrodenschicht (104, 204) hindurch erstrecken.

7. Vorrichtung nach einem der vorhergehenden Ansprüche, wobei die Elektroden der Vielzahl von Elektroden (106; 206a, 206b) regelmäßig in einem Feld angeordnet sind, wobei ein Zwischenraum der Elektroden (106; 206a, 206b) in dem Feld kleiner als 200 nm, wie etwa kleiner als 100 nm, ist.

8. Vorrichtung nach einem der vorhergehenden Ansprüche, wobei die aktive Schicht (102; 202) dazu konfiguriert ist, das optische Signal entlang der Erstreckung der aktiven Schicht (102; 202) zu verbreiten, wobei die aktive Schicht (102; 202) einen Kern eines Wellenleiters bildet, und die Elektrodenschicht (104; 204) eine Auskleidung des Wellenleiters bildet.

9. Vorrichtung nach einem der vorhergehenden Ansprüche, wobei eine Dicke der Elektrodenschicht (104; 204) mindestens 100 nm beträgt.

10. Vorrichtung nach einem der vorhergehenden Ansprüche, wobei die Elektrodenschicht (104; 204) dazu konfiguriert ist, gesteuert zu werden, um ein Verstärkungsmuster in der aktiven Schicht (102, 202) basierend auf einer Kombination von lokalen Modulationen durch die Vielzahl von Elektroden (106; 206a, 206b) zu definieren.

11. Vorrichtung nach einem der vorhergehenden Ansprüche, wobei die Elektrodenschicht eine erste Elektrodenschicht (104) ist und die Vorrichtung ferner eine zweite Elektrodenschicht (110) umfasst, wobei die aktive Schicht (102) zwischen der ersten Elektrodenschicht (104) und der zweiten Elektrodenschicht (110) gebildet ist, wobei die Vielzahl von Elektroden (106) der ersten Elektrodenschicht (104) dazu konfiguriert sind, ein erstes elektrisches Signal selektiv zu empfangen, und die zweiten Elektrodenschicht (110) dazu konfiguriert ist, ein zweites elektrisches Signal zu empfangen, wobei das erste und das zweite elektrische Signal eine entgegengesetzte Polarität aufweisen.

12. Vorrichtung nach einem der Ansprüche 1 bis 10, wobei die Elektroden (206) in der Vielzahl von Elektroden einen ersten Satz von Elektroden und einen zweiten Satz von Elektroden umfassen, wobei die Elektroden (206a) des ersten Satzes von Elektroden abwechselnd mit Elektroden (206b) des zweiten Satzes von Elektroden angeordnet sind, wobei die Elektroden (206a) des ersten Satzes von Elektroden dazu konfiguriert sind, ein erstes elektrisches Signal selektiv zu empfangen, und die Elektroden (206b) des zweiten Satzes von Elektroden dazu konfiguriert sind, ein zweites elektrisches Signal selektiv zu empfangen, wobei das erste und das zweite elektrische Signal eine entgegengesetzte Polarität aufweisen.

13. Vorrichtung nach einem der vorhergehenden Ansprüche, wobei die Vorrichtung (100; 200) dazu konfiguriert ist, einen Verstärkungsfaktor in der aktiven Schicht (102; 202) zu steuern, um eine Verstärkung des optischen Signals zu steuern, wie etwa eine optische Rückmeldung bereitzustellen, um ein Lasersignal zu bilden, und/oder eine Strahllenkung des optischen Signals, das von der Vorrichtung (100; 200) ausgegeben wird, oder ein dreidimensionales Muster, das durch das optische Signal gebildet wird, das von der Vorrichtung (100; 200) ausgegeben wird, zu steuern.

14. Verfahren zum Modulieren eines optischen Signals, wobei das Verfahren umfasst:
Generieren (302) des optischen Signals in einer aktiven Schicht;
Steuern (304) eines elektrischen Signals, das für jede einer Vielzahl von getrennten Elektroden in einer Elektrodenschicht bereitgestellt wird, die dazu angeordnet ist, sich entlang der aktiven Schicht zu erstrecken, wobei die Elektrodenschicht eine Vielzahl von getrennten Elektroden umfasst, die jeweiligen Teilen der aktiven Schicht zugeordnet sind, wobei jede Elektrode der Vielzahl von Elektroden eine Größe eines Querschnitts in der Elektrodenschicht aufweist, die kleiner als eine Wellenlänge des optischen Signals ist, und benachbarte Elektroden durch einen Abstand getrennt sind, der kleiner als die Wellenlänge des optischen Signals ist, wobei das elektrische Signal, das für jede der Vielzahl von getrennten Elektroden bereitgestellt wird, lokal einen imaginären Teil eines Brechungsindex der aktiven Schicht moduliert, indem ein elektrisches Signal in der aktiven Schicht lokal gesteuert wird.

## Revendications

1. Dispositif (100 ; 200) de modulation d'un signal optique, ledit dispositif comprenant :
une couche active (102 ; 202) configurée pour fournir un gain du signal optique commandé électriquement ;
une couche d'électrode (104 ; 204) agencée pour s'étendre le long de la couche active (102 ; 202), dans lequel la couche d'électrode (104 ; 204) comprend une pluralité d'électrodes séparées (106 ; 206a, 206b) associées à des parties respectives de la couche active (102 ; 200), dans lequel chaque électrode (106 ; 206a, 206b) de la pluralité d'électrodes présente une dimension de section transversale dans la couche d'électrode (104 ; 204) inférieure à une longueur d'onde du signal optique et les électrodes voisines sont séparées par une distance inférieure à la longueur d'onde du signal optique ; dans lequel un signal électrique appliqué à chacune de la pluralité d'électrodes séparées (106 ; 206a, 206b) peut être commandé pour moduler localement une partie imaginaire d'un indice de réfraction de la couche active (102 ; 202) en commandant localement un signal électrique dans la couche active (102 ; 202).

2. Dispositif selon la revendication 1, dans lequel chaque électrode (106 ; 206a, 206b) est associée à un circuit de commande individuel pour commander le signal électrique fourni à l'électrode (106 ; 206a, 206b).

3. Dispositif selon la revendication 1 ou 2, dans lequel le signal électrique appliqué à chacune de la pluralité d'électrodes séparées (106 ; 206a, 206b) est activé ou désactivé de manière sélective.

4. Dispositif selon une quelconque des revendications précédentes, dans lequel la couche d'électrode (104 ; 204) est formée par un métamatériau comprenant un matériau électriquement conducteur et un matériau isolant, dans lequel des parties du matériau électriquement conducteur forment la pluralité d'électrodes séparées (106 ; 206a, 206b).

5. Dispositif selon la revendication 4, dans lequel le matériau électriquement conducteur et le matériau isolant ont un même indice de réfraction.

6. Dispositif selon la revendication 4 ou 5, dans lequel les parties du matériau électriquement conducteur s'étendent à travers une épaisseur de la couche d'électrode (104 ; 204).

7. Dispositif selon une quelconque des revendications précédentes, dans lequel les électrodes de la pluralité d'électrodes (106 ; 206a, 206b) sont régulièrement disposées en un réseau, avec un pas des électrodes (106 ; 206a, 206b) dans le réseau inférieur à 200 nm, par exemple inférieur à 100 nm.

8. Dispositif selon une quelconque des revendications précédentes, dans lequel la couche active (102 ; 202) est configurée pour propager le signal optique le long de l'étendue de la couche active (102 ; 202), dans lequel la couche active (102 ; 202) forme un cœur d'un guide d'ondes et la couche d'électrode (104 ; 204) forme une gaine du guide d'ondes.

9. Dispositif selon une quelconque des revendications précédentes, dans lequel une épaisseur de la couche d'électrode (104 ; 204) est d'au moins 100 nm.

10. Dispositif selon une quelconque des revendications précédentes, dans lequel la couche d'électrode (104 ; 204) est configurée pour être commandée afin de définir un profil de gain dans la couche active (102 ; 202) sur la base d'une combinaison de modulations locales par la pluralité d'électrodes (106 ; 206a, 206b).

11. Dispositif selon une quelconque des revendications précédentes, dans lequel la couche d'électrode est une première couche d'électrode (104) et le dispositif comprend en outre une deuxième couche d'électrode (110), dans lequel la couche active (102) est formée entre la première couche d'électrode (104) et la deuxième couche d'électrode (110), dans lequel la pluralité d'électrodes (106) de la première couche d'électrode (104) sont configurées pour recevoir sélectivement un premier signal électrique et la deuxième couche d'électrode (110) est configurée pour recevoir un deuxième signal électrique, dans lequel les premier et deuxième signaux électriques ont des polarités opposées.

12. Dispositif selon une quelconque des revendications 1 à 10, dans lequel les électrodes (206) de la pluralité d'électrodes comprennent un premier ensemble d'électrodes et un deuxième ensemble d'électrodes, dans lequel des électrodes (206a) du premier ensemble d'électrodes sont disposées en alternance avec des électrodes (206b) du deuxième ensemble d'électrodes, dans lequel les électrodes (206a) du premier ensemble d'électrodes sont configurées pour recevoir sélectivement un premier signal électrique et les électrodes (206b) du deuxième ensemble d'électrodes sont configurées pour recevoir sélectivement un deuxième signal électrique, dans lequel les premier et deuxième signaux électriques ont des polarités opposées.

13. Dispositif selon une quelconque des revendications précédentes, dans lequel le dispositif (100 ; 200) est configuré pour commander le gain dans la couche active (102 ; 202) afin de commander l'amplification du signal optique, par exemple pour fournir une rétroaction optique en vue de former un signal laser et/ou pour commander l'orientation du faisceau du signal optique émis par le dispositif (100 ; 200) ou un motif tridimensionnel formé par le signal optique émis par le dispositif (100 ; 200).

14. Procédé de modulation d'un signal optique, ledit procédé comprenant
la génération (302) du signal optique dans une couche active ;
la commande (304) d'un signal électrique fourni à chacune d'une pluralité d'électrodes séparées situées dans une couche d'électrode et disposées de manière à s'étendre le long de la couche active, dans lequel la couche d'électrode comprend une pluralité d'électrodes séparées associées à des parties respectives de la couche active, dans lequel chaque électrode de la pluralité d'électrodes présente, dans la couche d'électrode, une section transversale de dimension inférieure à une longueur d'onde du signal optique et les électrodes voisines sont séparées par une distance inférieure à la longueur d'onde du signal optique, dans lequel le signal électrique fourni à chacune des électrodes séparées de la pluralité module localement une partie imaginaire d'un indice de réfraction de la couche active par la commande locale d'un signal électrique dans la couche active.
